# EUROPÄISCHE PATENTSCHRIFT

(11) **EP 4 106 200 B1**
(45) Veröffentlichungstag und Bekanntmachung des Hinweises auf die Patenterteilung: **09.08.2023**
(21) Anmeldenummer: 21180106.3
(22) Anmeldetag: 17.06.2021
(51) Int. Cl.: H03K 17/955

(54) **NÄHERUNGSSCHALTER MIT FUNKTIONALER SICHERHEIT**
PROXIMITY SWITCH WITH FUNCTIONAL SAFETY
INTERRUPTEUR DE PROXIMITÉ À SÉCURITÉ FONCTIONNELLE

(43) Veröffentlichungstag der Anmeldung: 21.12.2022
(73) Patentinhaber: Pepperl+Fuchs SE, 68307 Mannheim (DE)
(72) Erfinder: Eigemann, Lars, 68307 Mannheim (DE)
(74) Vertreter: Banse & Steglich Patentanwälte PartmbB

(56) Entgegenhaltungen:
- EP-A1- 1 928 091
- WO-A1-2019/219254
- WO-A2-2011/084919
- DE-A1- 10 345 819
- DE-A1-102020 107 704

## Beschreibung

### Technisches Gebiet

Die Erfindung betrifft Näherungsschalter zum Einsatz in sicherheitskritischen Anwendungen.

### Technischer Hintergrund

Der Einsatz von Schalteinrichtungen für technische Anlagen erfordert die Einhaltung vorgegebener Normen, wie beispielsweise ISO 13849-1, die die Festlegung von fünf Kategorien, nämlich B, 1, 2, 3, 4, für sicherheitsbezogene Komponenten von Maschinensteuerungen und Schutzeinrichtungen betrifft. Diese Kategorien orientieren sich an einem von der technischen Anlage ausgehenden Risiko für Menschen und Anlagen bei Einsatz derartiger Schalteinrichtungen. In den Kategorien B und 1 wird die Widerstandsfähigkeit gegen Fehler überwiegend durch Verwendung geeigneter Bauteile erreicht. Des Weiteren wird die Widerstandsfähigkeit gegenüber Fehler in den Kategorien 2, 3 und 4 überwiegend durch strukturelle Maßnahmen erreicht. Für eine Absicherung entsprechend der Kategorie 2 wird die Ausführung der Sicherheitsfunktion in regelmäßigen Abständen überprüft, und gemäß Kategorien 3 und 4 wird sichergestellt, dass das Auftreten eines einzelnen Fehlers nicht zum Verlust der Sicherheitsfunktion führen kann. In der Kategorie 4 werden zusätzlich solche Fehler selbsttätig erkannt. Weiterhin sind in der ISO 13849 bestimmte Leistungsniveaus (Performance Level) definiert, die basierend auf der Häufigkeit der Anforderung der Sicherheitsfunktion und der Wahrscheinlichkeit eines Ausfalls der Sicherheitsfunktion bestimmt sind.

Für das Auftreten eines Fehlers schreibt die EN 61508 das Einnehmen eines sicheren Zustands als einen Zustand eines technischen Systems vor, in dem Sicherheit erreicht ist. Dieser Zustand soll zuverlässig bei Auftreten eines Fehlers oder bei einer Störung der technischen Anlage eingenommen werden, um eine Gefährdung der technischen Anlage bzw. durch die technische Anlage aufgrund eines nicht-funktionalen Zustands sicher zu vermeiden.

Schalteinrichtungen im Sinne dieser Normen umfassen auch Näherungsschalter, die in vielfältiger Weise in technischen Anlagen eingesetzt werden. Für diese besteht ebenso die Anforderung, die entsprechenden Kriterien der geforderten Sicherheitsfunktion zu erfüllen. Somit gehört es auch bei Näherungsschaltern zu den grundlegenden Sicherheitsfunktionen dass bei Auftreten eines beliebigen Fehlers die ordnungsgemäße Funktion beibehalten oder ein sicherer Zustand des Näherungsschalters eingenommen werden muss.

Eine Möglichkeit, dies zu erreichen, ist in der Druckschrift DE 103 45 819 B4 offenbart. Darin ist ein Schaltgerät mit einem Sensorelement, mit einer Auswerteschaltung und mit einem Schalter offenbart, wobei die Auswerteschaltung mindestens zwei Bearbeitungseinheiten und eine Überwachungseinheit aufweist und die Ausgangssignale der Bearbeitungseinheiten in ihrer Konsistenz von der Überwachungseinheit überprüft werden, wobei das Ausgangssignal des Sensorelements sukzessive nacheinander an die Bearbeitungseinheiten gegeben wird.

Die Druckschrift WO 2011/084919A2 offenbart einen Näherungsschalter mit einer Messsonde und einem daran angeschlossenen ersten und zweiten Messpfad. Die Messpfade liefern jeweils ein Schaltsignal, das in einer Steuereinheit verarbeitet wird. Abhängig von den Schaltsignalen wird eine Ansteuerung des Schaltens der Kapazitäten der jeweiligen Messpfade vorgesehen.

Die Druckschrift WO2019/219254A1 offenbart einen kapazitiven Näherungssensor mit einem einzelnen Messpfad.

Die Druckschrift EP1 928 091 A1 offenbart eine Sensoreinheit, die mindestens eine Auswerteeinheit zur Auswertung eines Signals eines Sensors und zur Erzeugung eines auf dem Signal basierenden ersten Auslösesignals aufweist, wobei das Sicherheitssystem eine Überprüfungseinheit zur Funktionsprüfung der Auswerteeinheit mittels eines Testsignals aufweist.

Es ist Aufgabe der vorliegenden Erfindung, einen Näherungsschalter zur Verfügung zu stellen, der entsprechend der Norm EN 61508 bei Auftreten eines Fehlers einen sicheren Zustand einnimmt und in einfacher Weise realisiert werden kann.

### Offenbarung der Erfindung

Diese Aufgabe wird durch den Näherungsschalter mit funktionaler Sicherheit zum Einsatz in einer technischen Anlage gemäß Anspruch 1 gelöst.

Weitere Ausgestaltungen sind in den abhängigen Ansprüchen angegeben.

Gemäß einem ersten Aspekt ist ein Näherungsschalter mit funktionaler Sicherheit zum Bereitstellen eines sicheren Zustands bei Auftreten eines Fehlers vorgesehen, umfassend:
- eine Messsonde, die eine Messkapazität zu einem zu detektierenden Messobjekt bereitstellt;
- einen ersten Messpfad, um ein erstes Schaltsignal abhängig von einem Ladestrom zum Aufladen der Messkapazität auf eine vorgegebene Ladespannung bereitzustellen;
- einen zweiten Messpfad, um ein zweites Schaltsignal abhängig von einem Entladestrom zum Entladen der Messkapazität auf eine vorgegebene Entladespannung bereitzustellen;
- eine Schalteinrichtung für jeden der Messpfade, die jeweils so ausgelegt sind, um abhängig von dem ersten und dem zweiten Schaltsignal einen Schaltzustand einzunehmen, wobei die Schaltzustände der Schalteinrichtungen einen gemeinsamen Schaltzustand der Schalteinrichtungen definieren, wobei die Schalteinrichtungen so verschaltet sind, dass nur einer der möglichen gemeinsamen Schaltzustände ein Vorhandensein des Messobjekts angibt und die übrigen der möglichen gemeinsamen Schaltzustände ein Nichtvorhandensein des Messobjekts angeben.

Weiterhin sind die Schalteinrichtungen seriell gekoppelt, um eine UND-Verknüpfung bereitzustellen, um die Schaltzustände des ersten und des zweiten Schaltsignals zum Bereitstellen eines Zustands eines gemeinsamen Schaltsignals auszuwerten.

Weiterhin können der erste und der zweite Messpfad jeweils einen Operationsverstärker zum Wandeln des Ladestroms bzw. des Entladestroms in eine erste bzw. zweite Messspannung aufweisen, wobei ein erster Schaltkomparator für den ersten Messpfad vorgesehen ist, um die erste Messspannung mit einer entsprechenden Vergleichsspannung zu vergleichen und einen entsprechenden Zustand des ersten Schaltsignals bereitzustellen, wobei ein zweiter Schaltkomparator für den zweiten Messpfad vorgesehen ist, um die zweite Messspannung mit einer entsprechenden Vergleichsspannung zu vergleichen und einen entsprechenden Zustand des zweiten Schaltsignals bereitzustellen.

Die Zustände der Schaltsignale können so vorgesehen sein, dass diese die Schalteinrichtungen in den gemeinsamen Schaltzustand versetzen, der ein Vorhandensein des Messobjekts anzeigt, wenn die Zustände beider Schaltsignale sich auf dem Zustand befinden, der durch ein Über- bzw. Unterschreiten der jeweiligen Vergleichsspannung durch das erste und das zweite Messsignal eingenommen wurde.

Gemäß einer Ausführungsform können ein erster Schalter, insbesondere ein Analogschalter, z.B. ein Halbleiterschalter, für den ersten Messpfad und ein zweiter Schalter, insbesondere ein Analogschalter, z.B. ein Halbleiterschalter, für den zweiten Messpfad vorgesehen sein, um die Messkapazität zyklisch auf die vorgegebene Ladespannung zu laden und auf die vorgegebene Entladespannung zu entladen.

Kapazitive Näherungsschalter weisen eine elektrisch leitende Messsonde auf, die zu einem zu detektierenden Objekt eine Messkapazität bereitstellt, die von der Entfernung zwischen der Messsonde und dem zu detektierenden Objekt abhängt. Die Messkapazität wird gemessen, und mithilfe eines Schwellwertvergleichs kann festgestellt werden, ob ein Messobjekt innerhalb eines Messbereichs um die Messsonde vorhanden ist oder nicht.

Ein übliches Verfahren zur Messung der Messkapazität bei kapazitiven Näherungsschaltern umfasst eine Switched-Capacitor-Schaltung, bei der die Messkapazität zyklisch auf ein definiertes Spannungspotenzial aufgeladen wird und danach bis zu einem weiteren Spannungspotential entladen wird. Der Lade- und/oder Entladestrom wird ausgewertet und als Maß für die Größe der Messkapazität angenommen. Mithilfe eines Wandlers kann der Ladestrom und der Entladestrom in eine Messspannung umgewandelt werden.

Es ist üblich, die Switched-Capacitor-Schaltung in einem differentiellen Betrieb zu betreiben, bei der der Lade- und der Entladestrom in separaten Messpfaden gemessen werden und differentiell ausgewertet werden, um die Empfindlichkeit der Schaltung zu erhöhen. Dazu wird die Differenz der Messspannungen der separaten Messpfade mithilfe eines Schwellwertvergleichs ausgewertet, um ein Schaltsignal auszugeben, das von einem Vorhandensein oder Nichtvorhandensein des zu detektierenden Objekts in dem Messbereich abhängt bzw. dieses angibt.

Um Sicherheitsfunktionen nach ISO 13849 für Kategorien 2 oder höher zu realisieren, müssen strukturelle Maßnahmen angewendet werden, die entweder zur Überprüfung der korrekten Funktion der technischen Anlage oder einzelner Funktionsgruppen Fehler erkennt oder diese durch einen redundanten Aufbau ausschließt. Diese strukturellen Maßnahmen erfordern häufig einen zusätzlichen Hardware-Aufwand für die Ausbildung eines solchen Näherungsschalters.

Der obige kapazitive Näherungsschalter macht sich nun das Funktionsschema der symmetrischen Switched-Capacitor-Aufbauweise des differentiellen kapazitiven Näherungsschalters zunutze, um zwei voneinander unabhängige redundante Schaltsignale zu erhalten. Diese Schaltsignale werden separat durch die Umwandlung des Lade- und Entladestroms in eine entsprechende Messspannung und durch separate Schwellwertvergleiche erzeugt. Die Schaltzustände der Schaltsignale werden gemäß einer UND-Verknüpfung der Schaltsignale ausgewertet, und können insbesondere zum Ansteuern von seriell gekoppelten Schalteinrichtungen dienen. Die Schaltsignale werden so verknüpft, dass nur eine einzige Kombination von Schaltzuständen das Vorhandensein eines Messobjekts 3 anzeigt, während die übrigen Kombinationen das Nicht-Vorhandensein des Messobjekts anzeigen.

Somit werden die Messspannungen der beiden Messpfade des Näherungsschalters in Switched-Capacitor-Aufbauweise separat ausgewertet und mithilfe von separaten Komparatoren mit je einem Schwellenwert verglichen, um redundante Schaltsignale zu erzeugen. Die beiden voneinander unabhängigen Schaltsignale sind konsistent, wenn ein vollständiger Ladungsaustausch während eines Schaltzyklus zwischen beiden Ausgängen der Operationsverstärker der Messpfade und der Sonde gewährleistet ist und wenn beide Schaltschwellen über- bzw. unterschritten werden.

Die separate Auswertung der Messspannungen, die aus dem Ladestrom bzw. Entladestrom der Messkapazität bestimmt werden, ermöglicht es, das Schaltschema eines differentiell arbeitenden Näherungsschalters zu nutzen, um eine erhöhte funktionale Sicherheit zu erreichen.

Durch den Betrieb eines Näherungsschalters in der oben beschriebenen Weise mit einer separaten Auswertung der Messspannungen der Operationsverstärker kann ohne zusätzliche Baugruppen eine Sicherheitsfunktion nach Kategorie 2 der ISO 13849 oder höher realisiert werden. Der kapazitive Näherungsschalter stellt dazu zwei von der Messkapazität abhängige Messspannungen zur Verfügung, deren Generierung sich gegenseitig nicht beeinflusst.

Hierdurch wird implizit eine redundante Ausgestaltung des Näherungsschalters erreicht, ohne einen zusätzlichen Hardwareaufwand bereitstellen zu müssen.

Bei einer ordnungsgemäßen Funktion des Näherungsschalters ergibt sich bei Vorhandensein eines zu detektieren Objekts im Messbereich eine von der entsprechenden Ladespannung bzw. entsprechenden Entladespannung abweichende Messspannung in jedem Messpfad. Diese Messspannungen werden durch den Komparator gegen eine jeweilige Messschwelle verglichen und ein entsprechendes Schaltsignal für eine jeweilige Schalteinrichtung generiert.

Außerdem wird durch die Ausgestaltung der Sensorschaltung sichergestellt, dass beim Ausfall einer für die Sensorfunktion notwendigen Baugruppe mindestens ein Schaltsignal, d. h. eine Messspannung, in den sicheren Zustand, d. h. auf ein vorgegebenes Spannungspotential, wechselt. Weiterhin bleibt durch einen Ausfall einer Baugruppe zur Signalauswertung in einem der Messpfade des kapazitiven Näherungsschalters das Messsignal des unbeeinträchtigten Messpfads unbeeinflusst. Die Konsistenz der Messspannungen im betätigten Zustand ist dann gewährleistet, wenn die einzelnen Messpfade fehlerfrei funktionieren.

Fehler können in einem solchen Näherungsschalter in verschiedenen Komponenten auftreten. Ist während des Lade- und/oder des Entladevorgangs kein Ladungsaustausch zwischen einem Messpfad und der Messsonde möglich, so wird durch die separaten Messpfade gewährleistet, dass mindestens eines der resultierenden Schaltsignale in einen Schaltzustand wechselt, der dem Zustand eines Nichtvorhandenseins eines Messobjekts im Messbereich entspricht. Da die Schaltzustände, z.B. aufgrund der seriellen Verschaltung der durch die Schaltsignale gesteuerten Schalteinrichtungen, gemäß einer UND-Verknüpfung ausgewertet werden können, wird ein Vorhandensein eines Messobjekts nur durch einen gemeinsamen Schaltzustand angezeigt, bei dem beide Schaltzustände angeben, dass ein Messobjekt in dem Messbereich vorhanden ist. Der gemeinsame Schaltzustand, der ein Nicht-Vorhandensein des Messobjekts angibt, kann dann als sicherer Zustand angenommen werden.

Aufgrund eines Fehlers in einem der Messpfade zur Erzeugung des Schaltsignals kann die Messspannung des betroffenen Messpfades bzw. das resultierende Schaltsignal dauerhaft fehlerhaft sein, d.h. ein konstantes Potenzial bzw. Zustand annehmen. Die Messspannung und das resultierende Schaltsignal des anderen Messpfades bleiben durch den Fehler jedoch unbeeinflusst. Aufgrund der UND-Verknüpfung der durch das Schaltsignal bestimmten Schaltzustände wird bei einem fehlerhaften Messpfad entweder die Funktionsfähigkeit des Näherungssensors beibehalten oder es ergibt sich ein Schaltzustand, der einem vorgegebenen sicheren gemeinsamen Schaltzustand, d.h. ein Nichtvorhandensein eines Messobjekts, entspricht.

Gemäß einem weiteren Aspekt ist eine Anordnung vorgesehen, die den obigen Näherungsschalter und eine technische Anlage umfasst, die mit dem Näherungsschalter verbunden ist, um nur bei einem gemeinsamen Schaltzustand, der ein Vorhandensein des Messobjekts angibt, den ordnungsgemäßen Betrieb der Anlage zuzulassen.

Weiterhin kann die Anlage ein Eingabegerät und ein technisches Gerät umfassen, wobei das Eingabegerät mit dem technischen Gerät signaltechnisch verbunden ist, um das technische Gerät durch manuelle Bedienung zu bedienen, wobei das Eingabegerät mit der Messsonde des Näherungsschalters so versehen ist, dass bei einer manuellen Bedienung des Eingabegeräts das Vorhandensein des Messobjekts erkannt wird.

### Kurzbeschreibung der Zeichnungen

Ausführungsformen werden nachfolgend anhand der beigefügten Zeichnungen näher erläutert. Es zeigen:
- Figur 1: eine schematische Darstellung eines kapazitiven Näherungsschalters mit erhöhter funktionaler Sicherheit;
- Figur 2: ein Signal-Zeit-Diagramm zur Veranschaulichung der Funktionsweise des Näherungsschalters der Figur 1 im ordnungsgemäßen Betrieb;
- Figur 3: ein Signal-Zeit-Diagramm bei Auftreten eines Fehlers, der das Umladen der Messsonde verhindert; und
- Figuren 4a bis 4d: Signal-Zeit-Diagramme für jeweils das Auftreten eines Fehlers in einem der Messpfade, die das jeweilige Schaltsignal erzeugen;
- Figur 5: eine schematische Darstellung einer Anordnung mit einem Eingabegerät und einem Näherungsschalter zur Absicherung gegen eine ungewollte Bedienung.

### Beschreibung von Ausführungsformen

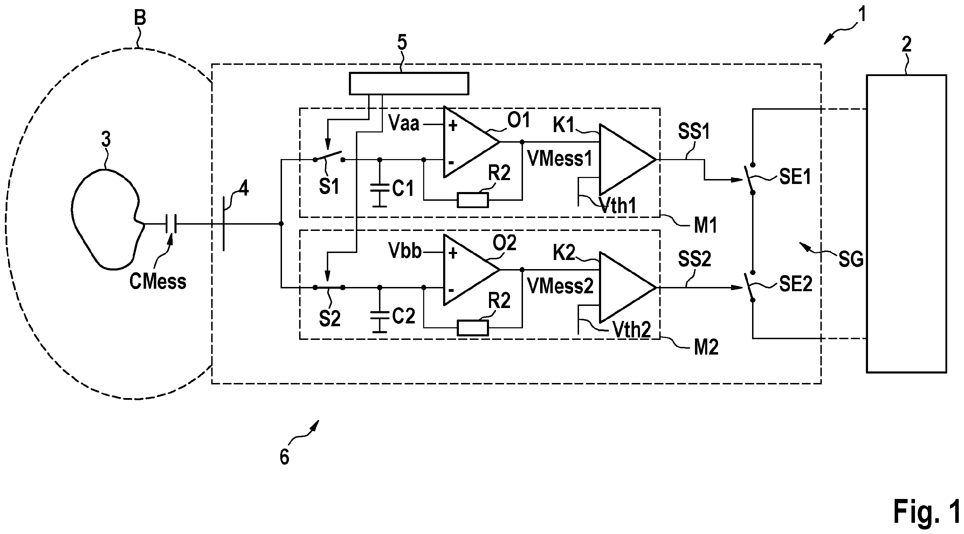

Figur 1 zeigt schematisch das Schaltbild eines kapazitiven Näherungsschalters 1 in Verbindung mit einer nachgeordneten Anlage 2, das mithilfe der sensorischen Erkennung eines Messobjekts betrieben wird. Der kapazitive Näherungsschalter 1 soll gemäß nachstehender Beschreibung mit erhöhter funktionaler Sicherheit ausgebildet sein. Die funktionale Sicherheit wird hierin dadurch gewährleistet, dass bei Auftreten eines Fehlers innerhalb des kapazitiven Näherungsschalters 1 entweder die Funktionalität des Näherungsschalters 1 weiterhin besteht oder der Zustand der durch den Näherungsschalter 1 geschalteten Anlage 2 auf einem sicheren Zustand verbleibt.

Der Näherungsschalter 1 weist eine Messsonde 4 auf, die zur kapazitiven Messung bezüglich eines sich in einem Messbereich B befindlichen zu detektierenden Messobjekts 3 ausgelegt ist. Je nach Vorhandensein oder Nichtvorhandensein eines Messobjekts 3 in dem Messbereich B stellt sich eine Kapazität CMess zwischen dem Messobjekt 3 und der Messsonde 4 ein, die mithilfe der nachfolgenden Schaltung des Näherungsschalters 1 gemessen wird.

Grundsätzlich arbeitet der Näherungsschalter 1 durch zyklisches Laden und Entladen der Messkapazität CMess und durch Auswerten des Lade- und Entladestroms. Dazu wird die Messkapazität CMess wechselweise mit einem ersten Messpfad M1 und einem zweiten Messpfad M2 über entsprechende erste und zweite Schalter S1, S2 verbunden. Im ersten Messpfad M1 ist ein erster Operationsverstärker O1 vorgesehen, dessen nicht invertierender Eingang mit einer Ladespannung Vaa belegt ist. Der Ausgang des ersten Operationsverstärkers O1 ist über einen ersten Widerstand R1 mit dem invertierenden Eingang des ersten Operationsverstärkers O1 verbunden. Der invertierende Eingang des ersten Operationsverstärkers O1 ist über den ersten Schalter S1 mit der Messkapazität CMess verbunden. Weiterhin ist der der invertierende Eingang des ersten Operationsverstärkers O1 mit einer ersten Speicherkapazität C1 verbunden.

Der zweite Messpfad M2 ist analog aufgebaut, wobei der nicht invertierende Eingang eines zweiten Operationsverstärkers O2 mit einer von der Ladespannung Vaa verschiedenen Entladespannung Vbb verbunden ist. Der Ausgang des zweiten Operationsverstärkers O2 ist über den zweiten Widerstand R2 mit dem invertierenden Eingang des zweiten Operationsverstärkers O2 verbunden. Der invertierende Eingang des zweiten Operationsverstärkers O2 ist ferner mit dem zweiten Schalter S2 verbunden. Der invertierende Eingang des zweiten Operationsverstärkers O2 ist entsprechend mit einer zweiten Speicherkapazität C2 verbunden.

Der erste und der zweite Schalter S1, S2 werden über eine Steuereinheit 5 vorzugsweise mit einer konstanten Schaltfrequenz (vorzugsweise Tastverhältnis 50%) zyklisch umgeschaltet, so dass stets nur einer der beiden Schalter S1, S2 geschlossen und der entsprechend andere geöffnet ist.

Ist im Messbereich B der Messsonde 4 kein zu detektierendes Messobjekt 3 vorhanden, so ist die Messkapazität CMess gering. Dies führt zu geringen Lade- und Entladeströmen, so dass sich an den Ausgängen des Operationsverstärkers O1, O2 eine erste und eine zweite Messspannung VMess1, VMess2 einstellt, die im Wesentlichen einer an dem jeweiligen Operationsverstärker O1, O2 anliegenden Lade- bzw. Entladespannung Vaa, Vbb entspricht. Bei Vorhandensein eines Messobjekts 3 steigt die Messkapazität CMess, und die Lade- und Entladeströme steigen deutlich an. Dies bewirkt, dass die erste Messspannung VMess1 ausgehend von der Ladespannung Vaa ansteigt und die zweite Messspannung VMess2 ausgehend von der Entladespannung Vbb abfällt.

Mithilfe eines ersten Schaltkomparators K1 wird die erste Messspannung VMess1 des ersten Messpfades M1 gegenüber einer ersten Vergleichsspannung Vth1 überprüft. Die erste Vergleichsspannung Vth1 ist vorzugsweise höher als die Ladespannung Vaa gewählt.

Analog wird die zweite Messspannung VMess2 an einen zweiten Schaltkomparator K2 angelegt, wobei die zweite Messspannung mit einer zweiten Vergleichsspannung Vth2 verglichen wird. Die zweite Vergleichsspannung Vth2 ist vorzugsweise niedriger als die Entladespannung Vbb gewählt. An den Ausgängen der Schaltkomparatoren K1, K2 wird ein erstes bzw. zweites Schaltsignal SS1, SS2 ausgegeben, mit dem beispielsweise eine erste bzw. zweite Schalteinrichtung SE1, SE2 (dargestellt als gesteuerte Schalter) betrieben wird.

Die erste und die zweite Schalteinrichtung SE1, SE2 sind zum Generieren eines gemeinsamen Schaltzustands SG logisch UND-verknüpft und schalten im ordnungsgemäßen Betrieb auf Durchlass, wenn beide Schalteinrichtungen SE1, SE2 geschlossen sind. Dadurch wird dem Gesamtsystem 2 angezeigt, dass das Messobjekt 3 im Messbereich B vorhanden ist. Im vorliegenden Ausführungsbeispiel zeigt der gesamte Schaltzustand SG ein Vorhandensein eines Messobjekts 3 an, wenn der erste Schaltzustand SS1 einen "1"-Zustand und der zweite Schaltzustand SS2 einen "0"-Zustand innehat.

Die Schaltsignale SS1, SS2 an den Ausgängen der Schaltkomparatoren K1, K2 steuern die jeweilige Schalteinrichtung SE1, SE2 so an, dass nur wenn die erste Vergleichsspannung Vth1 und die zweite Vergleichsspannung Vth2 über- bzw. unterschritten sind, ein Messobjekt 3 im Messbereich B der Messsonde 4 erkannt wird. Das heißt, nur wenn in beiden Messpfaden M1, M2 eine Spannungsänderung der ersten und zweiten Messspannung VMess1, VMess2 über die erste Vergleichsspannung Vth1 bzw. unter die zweite Vergleichsspannung Vth2 gelangt, wird ein Messobjekt 3 als vorhanden erkannt.

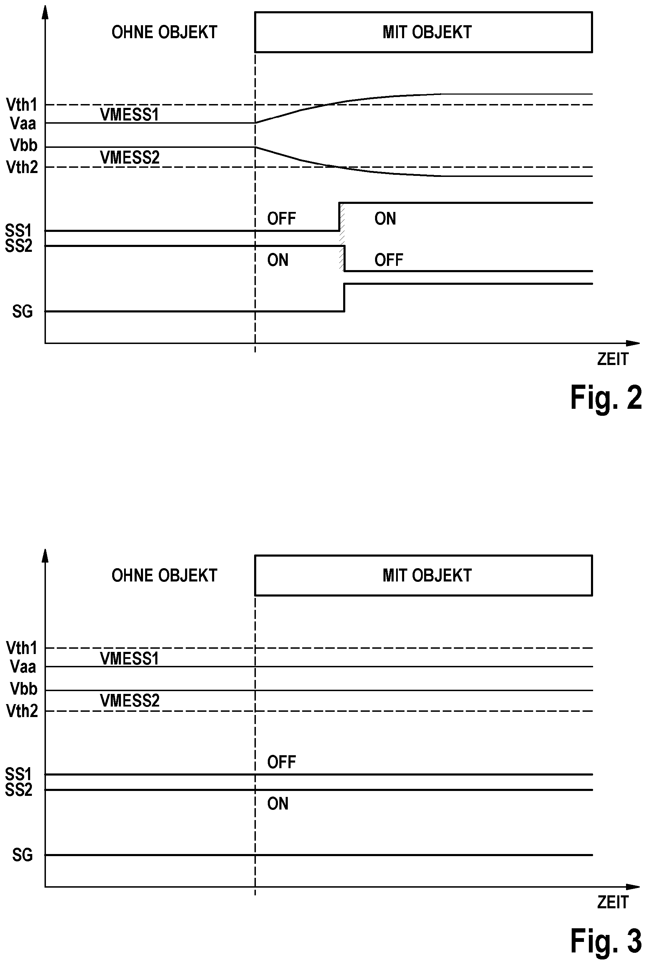

Bei einem ordnungsgemäßen Betrieb des Näherungsschalters 1 erhält man für die Messspannungen VMess1, VMess2 und die Schaltsignale SS1, SS2 einen Signal-ZeitVerlauf, wie er in Figur 2 dargestellt ist. Man erkennt, dass bei Eintreten eines Messobjekts 3 in den Messbereich B der Messsonde 3 der Ladestrom und der Entladestrom ansteigen und dadurch die erste und zweite Messspannung VMess1, VMess2 von der Ladespannung Vaa bzw. der Entladespannung Vbb abweichen. Die erste Messspannung VMess1 steigt ausgehend von der Ladespannung Vaa an, während die zweite Messspannung VMess2 ausgehend von der Entladespannung V_{bb} abfällt. Überschreitet die erste Messspannung VMess1 die erste Vergleichsspannung Vth1, so geht das Schaltsignal SS1 auf einen "1"-Zustand. Unterschreitet die zweite Messspannung VMess2 die zweite Vergleichsspannung Vth2, so nimmt das zweite Schaltsignal SS2 einen "0"-Zustand ein. Die Schaltsignale SS1, SS2 bestimmen den Schaltzustand der Schalteinrichtungen SE1, SE2. Die Schaltzustände der Schalteinrichtungen SE1, SE2 bestimmen den gemeinsamen Schaltzustand, der dem Gesamtsystem 2 anzeigt, ob ein Messobjekt 3 vorhanden ist oder nicht. Die Schaltsignale SS1, SS2 werden so verknüpft, dass nur eine einzige Kombination von Schaltzuständen das Vorhandensein eines Messobjekts 3 anzeigt.

In den hierin beschriebenen Ausführungsformen sind die Schaltsignale SS1, SS2 antivalent definiert, d.h. ein "1"-Zustand des ersten Schaltsignals SS1, schließt die erste Schalteinrichtung SE1, ein "0"-Zustand des ersten Schaltsignals SS1, öffnet die erste Schalteinrichtung SE1, ein "1"-Zustand des zweiten Schaltsignals SS2, öffnet die zweite Schalteinrichtung SE2 und ein "0"-Zustand des zweiten Schaltsignals SS1, schließt die zweite Schalteinrichtung SE2. Auch andere Konfigurationen sind jedoch denkbar.

Zum Bereitstellen der funktionalen Sicherheit eines solchen Näherungsschalters 1 ist es notwendig, dass bei verschiedenen auftretenden Fehlern die Funktionalität des Näherungsschalters 1 beibehalten wird oder der gemeinsame Schaltzustand der Schalteinrichtungen SE1, SE2 des Näherungsschalters 1 auf einem vorgegebenen Zustand verbleibt bzw. auf diesen zurückgeht. Dieser vorgegebene gemeinsame Schaltzustand entspricht im vorgegebenen Fall einem Schaltzustand, der das Nichtvorhandensein eines zu detektierenden Messobjekts 3 im Messbereich anzeigt. Dazu ist es ausreichend, wenn einer der Schalteinrichtungen SE1, SE2 geöffnet ist. Nur wenn beide Schalteinrichtungen geschlossen sind, zeigt der gemeinsame Schaltzustand ein Vorhandensein eines Messobjekts im Messbereich an.

Durch einen Fehler in dem Näherungsschalter 1, der zur Folge hat, dass der Ladungsaustausch zwischen den Ausgängen der Operationsverstärker O1, O2 und der Messkapazität CMess nicht mehr möglich ist, verliert die Schaltung insgesamt ihre Funktionalität. Damit wird in keinem der Messpfade M1, M2 eine Spannungsdifferenz gegenüber der entsprechenden Ladespannung Vaa bzw. der entsprechenden Entladespannung Vbb erreicht, und die Schaltkomparatoren K1, K2 liefern kein Schaltsignal SS1, SS2, das über die entsprechenden Schaltkomparatoren K1, K2 in den Schalteinrichtungen SE1, SE2 das Erkennen des Messobjekts 3 anzeigt. Ein solcher Fall ist durch das Signal-Zeit-Diagramm der Figur 3 angegeben.

Das Auftreten eines Fehlers in einem der beiden Messpfade M1, M2, durch das die erste oder die zweite Messspannung VMess1, VMess2 dauerhaft fehlerhaft bereitgestellt wird, beeinflusst jedoch nicht die Funktionalität des entsprechend anderen Messpfades M2, M1. Die sich ergebende Funktionalität stellt entweder einen gesamten Schaltzustand SG bereit, der ordnungsgemäß das Vorhandensein oder Nichtvorhandensein des Messobjekts 3 anzeigt oder es wird ein sicherer Zustand als gesamter Schaltzustand SG angenommen, in diesem Fall zeigt dieser das Nicht-Vorhandensein des Messobjekts an.

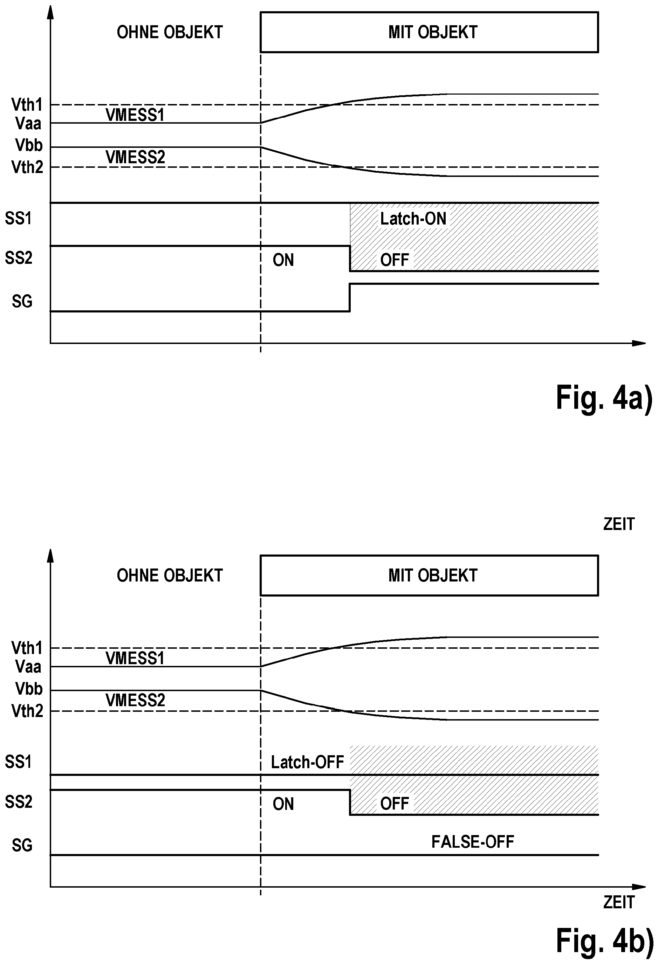

Im Folgenden werden in Verbindung mit den Signal-Zeit-Diagrammen der Figuren 4a bis 4d mögliche Fehlerfälle in den Messpfaden M1, M2 diskutiert. Die Fehlerfälle in den Messpfaden resultieren darin, dass als digitales Schaltsignal SS1, SS2 des fehlerhaften Messpfades M1, M2 ein konstanter "1"-Pegel oder ein konstanter "O"-Pegel ausgegeben wird.

In Figur 4a ist der Fehlerfall dargestellt, bei dem das erste Schaltsignal SS1 des ersten Messpfades M1 dauerhaft auf einem "1"-Zustand ist, während der zweite Messpfad M2 ordnungsgemäß arbeitet. In diesem Fall wird die Erkennung des Vorhandenseins oder Nichtvorhandenseins des Messobjekts 3 nicht beeinträchtigt, da der erste Messpfad den "1"-Zustand bereits innehat und der zweite Messpfad M2 die Messung ordnungsgemäß vornehmen kann und der gemeinsame Schaltzustand SG am Ausgang des Näherungsschalters 1 das Vorhandensein oder Nichtvorhandensein des Messobjekts 3 wie zuvor anzeigt.

In Figur 4b wird der Fehlerfall dargestellt, bei dem der erste Messpfad M1 dauerhaft ein erstes Schaltsignal SS1 bewirkt, das auf einem "0"-Zustand verbleibt. Dadurch wird die Bereitstellung eines gemeinsamen Schaltzustands SG am Ausgang des Näherungsschalters 1 blockiert, der anzeigt, dass ein Messobjekt 3 im Messbereich B vorhanden ist. Am Ausgang des Näherungsschalters 1 liegt somit immer ein gemeinsamer Schaltzustand SG vor, der angibt, dass kein Messobjekt 3 vorhanden ist, ungeachtet, ob tatsächlich ein Messobjekt 3 im Messbereich vorhanden ist (False-off). Dieses entspricht dem sicheren Zustand des Näherungsschalters 1, der die funktionale Sicherheit des Gesamtsystems 2 weiterhin gewährleistet.

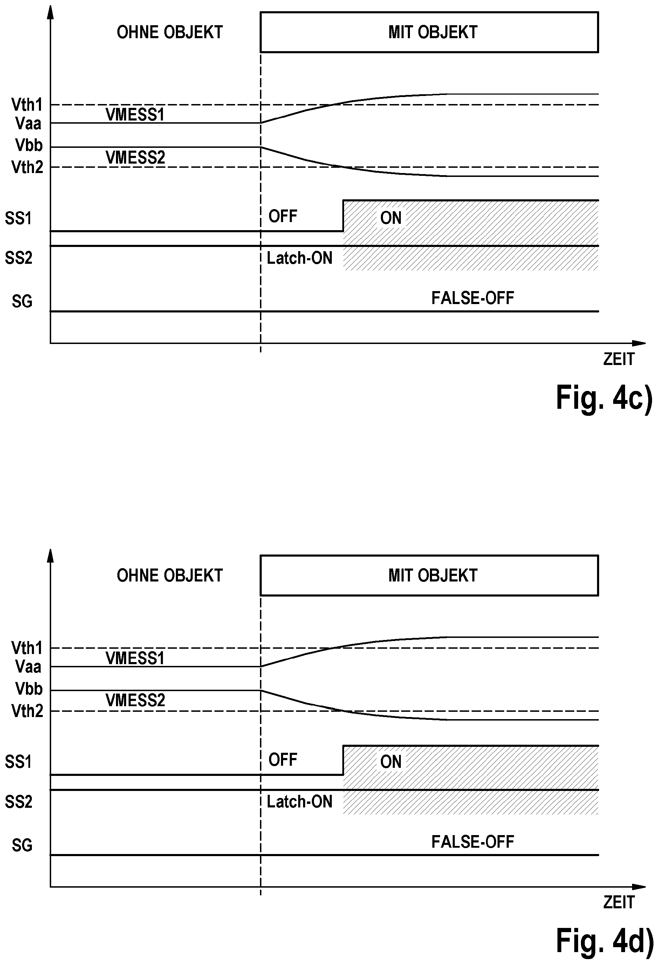

Im Fehlerfall, der in der Figur 4c dargestellt ist, ist das zweite Schaltsignal SS2 des zweiten Messpfades M2 dauerhaft auf einem "1"-Zustand, während der erste Messpfad M1 ordnungsgemäß arbeitet. In diesem Fall wird die Erkennung des Vorhandenseins oder Nichtvorhandenseins des Messobjekts 3 nicht beeinträchtigt, da der zweite Messpfad M2 den "1"-Zustand bereits innehat und der erste Messpfad M1 die Messung ordnungsgemäß vornehmen kann und der gemeinsame Schaltzustand SG am Ausgang des Näherungsschalters 1 das Vorhandensein oder Nichtvorhandensein des Messobjekts 3 wie zuvor anzeigt.

In Figur 4d wird der Fehlerfall dargestellt, bei dem der zweite Messpfad M2 dauerhaft ein zweites Schaltsignal SS2 bewirkt, das auf einem "0"-Zustand verbleibt. Dadurch wird die Bereitstellung eines gemeinsamen Schaltzustands SG am Ausgang des Näherungsschalters 1 blockiert, der anzeigt, dass ein Messobjekt 3 im Messbereich B vorhanden ist. Am Ausgang des Näherungsschalters 1 liegt somit immer ein gemeinsamer Schaltzustand SG vor, der angibt, dass kein Messobjekt 3 vorhanden ist, ungeachtet, ob tatsächlich ein Messobjekt 3 im Messbereich vorhanden ist (False-off). Dieses entspricht dem sicheren Zustand des Näherungsschalters 1, der die funktionale Sicherheit des Gesamtsystems 2 weiterhin gewährleistet.

Man erkennt, dass bei Auftreten eines Fehlers in keinem Fall ein Zustand am Ausgang des Näherungsschalters 1 angenommen wird, der das Vorhandensein eines Messobjekts 3 im Messbereich anzeigt, wenn tatsächlich kein Messobjekt 3 vorhanden ist. Im Fehlerfall kann entweder der Näherungsschalter 1 ordnungsgemäß weiter betrieben werden oder der Ausgang des Näherungsschalters 1 nimmt den sicheren Zustand ein, nämlich den Zustand, der das Nichtvorhandensein des Messobjekts 3 anzeigt.

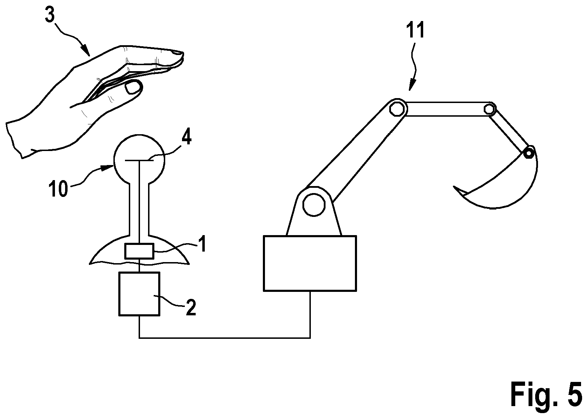

Wie in Figur 5 dargestellt, kann ein solcher Näherungsschalter 1 beispielsweise in einem Eingabegerät 10, wie z.B. einem Joystick, zur Steuerung eines technischen Geräts 11, wie z.B. ein Schaufelarm eines Baggers, als Beispiel für eine Anlage 2 eingesetzt werden. Da der kapazitive Näherungsschalter 1 das Vorhandensein eines Körperteils wie z.B. einer bedienenden Hand detektieren kann, kann die Bedienmöglichkeit durch das Eingabegerät 10 nur dann zugelassen werden, wenn ein Vorhandensein eines detektierbaren Objekts, wie z.B. der Hand, erkannt wird. Einwirkungen auf das Eingabegerät 10 durch andere Objekte, die aufgrund fehlender oder geringer elektrischer Leitfähigkeit oder abweichender relativer Dielektrizitätskonstante nicht durch den Näherungsschalter 1 detektiert werden können, führen dann zu keiner gültigen Eingabe. Eine versehentliche Bedienung des Geräts11 kann dann unterdrückt werden, wenn gleichzeitig mit der Bedienung des Eingabegeräts 10 kein Vorhandensein (Nicht-Vorhandensein) eines Objekts durch den Näherungsschalter 1 detektiert wird.

Bei Auftreten eines Fehlers, der zu einer dauerhaften Signalisierung eines NichtVorhandenseins eines Objekts führt, führt dann zu einer Deaktivierung des Eingabegeräts für weitere Eingaben, so dass auch in einem Fehlerfall kritische Zustände durch eine ungewollte Bedienung vermieden werden können.

### Bezugszeichenliste

- 1: Näherungsschalter
- 2: Anlage
- 3: Messobjekt
- 4: Messsonde
- 5: Steuereinheit
- B: Messbereich
- CMess: Messkapazität
- M1: erster Messpfad
- M2: zweiter Messpfad
- S1: erster Schalter
- S2: zweiter Schalter
- O1: erster Operationsverstärker
- Vaa: Ladespannung
- R1: erster Widerstand
- C1: erste Speicherkapazität
- O2: zweiter Operationsverstärker
- Vbb: Entladespannung
- R2: zweiter Widerstand
- C2: zweite Speicherkapazität
- VMess1, VMess2: erste und zweite Messspannung
- K1: erster Schaltkomparator
- Vth1: erste Vergleichsspannung
- K2: zweiter Schaltkomparator
- Vth2: zweite Vergleichsspannung
- SS1, SS2: erstes und zweites Schaltsignal
- SE1: erste Schalteinrichtung
- SE2: zweite Schalteinrichtung
- SG: gemeinsamer Schaltzustand
- 10: Eingabegerät
- 11: technisches Gerät

## Patentansprüche

1. Näherungsschalter (1) zum Bereitstellen eines sicheren Zustands bei Auftreten eines Fehlers, umfassend:
- eine Messsonde (4), die eine Messkapazität (CMess) zu einem zu detektierenden Messobjekt (3) bereitstellt;
- einen ersten Messpfad (M1), der ausgebildet ist, um ein erstes Schaltsignal (SS1) abhängig von einem Ladestrom zum Aufladen der Messkapazität (CMess) auf eine vorgegebene Ladespannung (Vaa) bereitzustellen;
- einen zweiten Messpfad (M2), der ausgebildet ist, um ein zweites Schaltsignal (SS2) abhängig von einem Entladestrom zum Entladen der Messkapazität (CMess) auf eine vorgegebene Entladespannung (Vbb) bereitzustellen;
- eine Schalteinrichtung (SE1, SE2) für jeden der Messpfade (M1, M2), die jeweils so ausgelegt sind, um abhängig von dem ersten und dem zweiten Schaltsignal (SS1, SS2) einen Schaltzustand einzunehmen, wobei die Schaltzustände der Schalteinrichtungen (SE1, SE2) einen gemeinsamen Schaltzustand (SG) der Schalteinrichtungen (SE1, SE2) definieren, wobei die Schalteinrichtungen (SE1, SE2) seriell gekoppelt sind, um eine UND-Verknüpfung bereitzustellen, um die Schaltzustände des ersten und des zweiten Schaltsignals (SS1, SS2) zum Bereitstellen eines Zustands eines gemeinsamen Schaltsignals (SG) auszuwerten, so dass nur einer der möglichen gemeinsamen Schaltzustände ein Vorhandensein des Messobjekts (3) angibt und die übrigen der möglichen gemeinsamen Schaltzustände (SG) ein Nichtvorhandensein des Messobjekts (3) angeben.

2. Näherungsschalter (1) nach Anspruch 1, wobei der erste und der zweite Messpfad (M1, M2) jeweils einen Operationsverstärker (O1, O2) zum Wandeln des Ladestroms (Vaa) bzw. des Entladestroms (Vbb) in eine erste bzw. zweite Messspannung (VMess1, VMess2) aufweist, wobei ein erster Schaltkomparator (K1) für den ersten Messpfad (M1) vorgesehen ist, um die erste Messspannung (VMess1) mit einer entsprechenden Vergleichsspannung (Vth1, Vth2) zu vergleichen und einen entsprechenden Zustand des ersten Schaltsignals (SS1) bereitzustellen, wobei ein zweiter Schaltkomparator (K2) für den zweiten Messpfad (M2) vorgesehen ist, um die zweite Messspannung (VMess2) mit einer entsprechenden Vergleichsspannung (Vth1, Vth2) zu vergleichen und einen entsprechenden Zustand des zweiten Schaltsignals (SS2) bereitzustellen.

3. Näherungsschalter (1) nach Anspruch 2, wobei die Zustände der Schaltsignale so vorgesehen sind, dass diese die Schalteinrichtungen (SE1, SE2) in den gemeinsamen Schaltzustand (SG) versetzen, der ein Vorhandensein des Messobjekts (3) anzeigt, wenn die Zustände beider Schaltsignale (SS1, SS2) sich auf dem Zustand befinden, der durch ein Überschreiten oder Unterschreiten der jeweiligen ersten oder zweiten Vergleichsspannung (Vth1, Vth2) durch die erste (VMess1) bzw. die zweite Messspannung (VMess2) eingenommen wurde.

4. Näherungsschalter (1) nach einem der Ansprüche 1 bis 3, wobei ein erster Schalter (S1) für den ersten Messpfad (M1) und ein zweiter Schalter (S2) für den zweiten Messpfad (M2) vorgesehen ist, um die Messkapazität (CMess) zyklisch auf die vorgegebene Ladespannung (Vaa) zu laden und auf die vorgegebene Entladespannung (Vbb) zu entladen.

5. Anordnung, umfassend:
einen Näherungsschalter (1) nach einem der Ansprüche 1 bis 4;
eine technische Anlage, die mit dem Näherungsschalter (1) verbunden ist, um nur bei einem gemeinsamen Schaltzustand (SG), der ein Vorhandensein des Messobjekts (3) angibt, den ordnungsgemäßen Betrieb der Anlage zuzulassen.

6. Anordnung nach Anspruch 5, wobei die Anlage ein Eingabegerät (10) und ein technisches Gerät (11) umfasst, wobei das Eingabegerät (10) mit dem technischen Gerät (11) signaltechnisch verbunden ist, um das technische Gerät (11) durch manuelle Bedienung zu bedienen, wobei das Eingabegerät (10) mit der Messsonde (4) des Näherungsschalters (1) so versehen ist, dass bei einer manuellen Bedienung des Eingabegeräts (10) das Vorhandensein des Messobjekts (3) erkannt wird.

## Claims

1. A proximity switch (1) for providing a safe state when a fault occurs, comprising:
- a measuring probe (4) which provides a measuring capacitance (CMess) related to an object (3) to be detected;
- a first measurement path (M1) configured to provide a first switching signal (SS1) dependent on a charging current for charging the measurement capacitance (CMess) onto a predetermined charging voltage (Vaa);
- a second measuring path (M2) which is designed to provide a second switching signal (SS2) as a function of a discharge current for discharging the measuring capacitance (CMess) onto a predetermined discharge voltage (Vbb);
- a switching device (SE1, SE2) for each of the measurement paths (M1, M2), each of which is configured to set a switching state in dependence on the first and the second switching signal (SS1, SS2), the switching states of the switching devices (SE1, SE2) defining a common switching state (SG) of the switching devices (SE1, SE2), the switching devices (SE1, SE2) being serially coupled to provide an AND operation to evaluate the switching states of the first and second switching signals (SS1, SS2) to provide a state of a common switching signal (SG), such that only one of the possible common switching states indicates a presence of the sensing object (3) and the remaining ones of the possible common switching states (SG) indicate a non-presence of the sensing object (3).

2. The proximity switch (1) according to claim 1, wherein the first and the second measuring paths (M1, M2) each comprise an operational amplifier (O1, O2) for converting the charging current (Vaa) and the discharging current (Vbb) into a first and a second measuring voltage (VMess1, VMess2) , respectively, a first switching comparator (K1) being provided for the first measuring path (M1) in order to compare the first measuring voltage (VMess1) with a corresponding comparison voltage (Vth1, Vth2) and to provide a corresponding state of the first switching signal (SS1), wherein a second switching comparator (K2) for the second measuring path (M2) is provided for comparing the second measuring voltage (VMess2) with a corresponding comparison voltage (Vth1, Vth2) and providing a corresponding state of the second switching signal (SS2).

3. The proximity switch (1) according to claim 2, wherein the states of the switching signals are provided such that they set the switching devices (SE1, SE2) to the common switching state (SG) indicating a presence of the object (3) to be detected when the states of both switching signals (SS1, SS2) are at the state indicated by exceeding or falling below the respective first or second comparison voltage (Vth1, Vth2) by the first (VMess1) or the second measuring voltage (VMess2), resepctively.

4. The proximity switch (1) according to any one of claims 1 to 3, wherein a first switch (S1) is provided for the first measurement path (M1) and a second switch (S2) is provided for the second measurement path (M2) for cyclically charging the measurement capacitance (CMess) to the predetermined charging voltage (Vaa) and discharging it to the predetermined discharging voltage (Vbb).

5. An arrangement comprising:
- a proximity switch (1) according to any one of claims 1 to 4;
- a technical installation connected to the proximity switch (1) to allow proper operation of the installation only in case of a common switching state (SG) indicating a presence of the object (3) to be detected.

6. The arrangement according to claim 5, wherein the installation comprises an input device (10) and a technical device (11), wherein the input device (10) is signal-connected to the technical device (11) in order to operate the technical device (11) by manual operation, wherein the input device (10) is provided with the measuring probe (4) of the proximity switch (1) in such a way that the presence of the object (3) to be detected is detected when the input device (10) is operated manually.

## Revendications

1. Détecteur de proximité (1) pour fournir un état sûr en cas d'apparition d'un défaut, comprenant :
- une sonde de mesure (4) qui fournit une capacité de mesure (CMess) à un objet de mesure (3) à détecter ;
- un premier chemin de mesure (M1) qui est conçu pour fournir un premier signal de commutation (SS1) en fonction d'un courant de charge pour charger la capacité de mesure (CMess) à une tension de charge prédéterminée (Vaa) ;
- un deuxième chemin de mesure (M2) qui est conçu pour fournir un deuxième signal de commutation (SS2) en fonction d'un courant de décharge pour décharger la capacité de mesure (CMess) à une tension de décharge prédéterminée (Vbb) ;
- un dispositif de commutation (SE1, SE2) pour chacun des chemins de mesure (M1, M2), chacun étant conçu pour prendre un état de commutation en fonction du premier et du deuxième signal de commutation (SS1, SS2), les états de commutation des dispositifs de commutation (SE1, SE2) définissant un état de commutation commun (SG) des dispositifs de commutation (SE1, SE2), les dispositifs de commutation (SE1, SE2) étant couplés en série, pour fournir une combinaison ET afin d'évaluer les états de commutation des premier et deuxième signaux de commutation (SS1, SS2) pour fournir un état d'un signal de commutation commun (SG), de sorte qu'un seul des états de commutation communs possibles indique une présence de l'objet de mesure (3) et que les autres des états de commutation communs possibles (SG) indiquent une absence de l'objet de mesure (3).

2. Détecteur de proximité (1) selon la revendication 1, dans lequel le premier et le deuxième chemin de mesure (M1, M2) comprennent chacun un amplificateur opérationnel (O1, O2) pour convertir le courant de charge (Vaa) ou le courant de décharge (Vbb) en une première ou une deuxième tension de mesure (VM). un premier comparateur de commutation (K1) est prévu pour le premier chemin de mesure (M1) afin de comparer la première tension de mesure (VMess1) à une tension de comparaison correspondante (Vth1, Vth2) et de fournir un état correspondant du premier signal de commutation (SS1), dans lequel un deuxième comparateur de commutation (K2) est prévu pour le deuxième chemin de mesure (M2) afin de comparer la deuxième tension de mesure (VMess2) à une tension de comparaison correspondante (Vth1, Vth2) et de fournir un état correspondant du deuxième signal de commutation (SS2).

3. Détecteur de proximité (1) selon la revendication 2, dans lequel les états des signaux de commutation sont prévus de telle sorte qu'ils placent les dispositifs de commutation (SE1, SE2) dans l'état de commutation commun (SG) qui indique une présence de l'objet de mesure (3) lorsque les états des deux signaux de commutation (SS1, SS2) se trouvent dans l'état qui est déterminé par un dépassement vers le haut ou vers le bas de la première ou de la deuxième tension de comparaison respective (Vth1, Vth2) par la première (VMess1) ou la deuxième (VMess2) tension de comparaison. la deuxième tension de mesure (VMess2).

4. Détecteur de proximité (1) selon l'une des revendications 1 à 3, dans lequel un premier commutateur (S1) est prévu pour le premier chemin de mesure (M1) et un deuxième commutateur (S2) est prévu pour le deuxième chemin de mesure (M2), afin de charger la capacité de mesure (CMess) de manière cyclique à la tension de charge prédéterminée (Vaa) et de la décharger à la tension de décharge prédéterminée (Vbb).

5. Dispositif comprenant :
un détecteur de proximité (1) selon l'une des revendications 1 à 4 ;
une installation technique reliée au détecteur de proximité (1) pour n'autoriser le bon fonctionnement de l'installation que dans un état de commutation commun (SG) indiquant une présence de l'objet de mesure (3).

6. Dispositif selon la revendication 5, dans lequel l'installation comprend un appareil d'entrée (10) et un appareil technique (11), l'appareil d'entrée (10) étant relié à l'appareil technique (11) par une technique de signalisation afin de commander l'appareil technique (11) par une commande manuelle, l'appareil d'entrée (10) étant pourvu de la sonde de mesure (4) du détecteur de proximité (1) de telle sorte que la présence de l'objet de mesure (3) est détectée lors d'une commande manuelle de l'appareil d'entrée (10).
